Europäisches Patentamt

**European Patent Office**

**Office européen des brevets**

(19)

(11) Numéro de publication: **0 061 983**

**A1**

(12)

# DEMANDE DE BREVET EUROPEEN

(21) Numéro de dépôt: **82440009.7**

(22) Date de dépôt: **16.03.82**

(51) Int. Cl.³: **G 01 R 19/155**

(30) Priorité: **26.03.81 FR 8106259**

(43) Date de publication de la demande:
**06.10.82 Bulletin 82/40**

(84) Etats contractants désignés:
**AT BE CH DE GB IT LI LU NL SE**

(71) Demandeur: **Singer, Edouard**
**53, rue de Mulhouse**
**F-68790 Morschwiller-Le-Bas(FR)**

(72) Inventeur: **Singer, Edouard**
**53, rue de Mulhouse**
**F-68790 Morschwiller-Le-Bas(FR)**

(74) Mandataire: **Aubertin, François**
**Cabinet BUGNION PROPRIETE INDUSTRIELLE 4, rue de**
**Haguenau**
**F-67000 Strasbourg(FR)**

(54) **Perfectionnement aux dispositifs portatifs de vérification d'absence de tension sur des installations à haute et très haute tension alternative.**

(57) Un dispositif portatif unipolaire de vérification d'absence de tension sur des installations à haute et très haute tension alternative à seuil de fonctionnement variable mais déterminé comprenant une sonde conductrice (1), un blindage protecteur (2), des moyens avertisseurs (11) qui fonctionnent lorsque la tension d'exploitation dépasse ledit seuil et comportant un étage redresseur (5, 6) transformant une fraction de la tension alternative en tension sensiblement continue qui est comparée à un seuil variable mais déterminé

FIG.1

EP 0 061 983 A1

Perfectionnement aux dispositifs portatifs de vérification d'absence de tension sur des installations à haute et très haute tension alternative.

L'invention concerne un dispositif portatif unipolaire de vérification d'absence de tension sur des installations à haute et très haute tension alternative à seuil de fonctionnement variable mais déterminé, comprenant une sonde conductrice, un blindage protecteur et des moyens avertisseurs qui fonctionnent lorsque la tension d'exploitation dépasse ledit seuil.

En vue d'écarter des accidents corporels au cours des travaux d'exploitation, de construction ou d'entretien sur des installations à haute et très haute tension, des prescriptions strictes de sécurité sont à observer.

Les travaux sur des installations à haute et très haute tension ne doivent être exécutés qu'après mise "hors tension" de ces installations, c'est-à-dire coupées de toute source d'énergie.

Elles ne peuvent être considérées comme "hors tension" que si l'absence de tension effective a été vérifiée.

Puis, on procède à leur mise en court circuit et à la terre.

On sait que la tension induite au sol sous une ligne de 420 kV peut atteindre 60kV. Elle est d'une valeur supérieure sur des lignes de 750 et de 1 million de Volts, sous tension.

Or, un conducteur normalement coupé de toute alimentation peut être porté à un certain potentiel par induction électro-magnétique ou par influence de champs électriques à proximité d'ouvrages à haute et très haute tension. On connaît déjà des vérificateurs portatifs d'absence de tension montés sur des perches isolantes comportant une lampe au néon.

Le fonctionnement de ces détecteurs exige la création d'une fuite à la terre à travers l'opérateur qui touche l'extrémité d'une résistance de protection de la lampe au néon. Ces dispositifs conviennent pour la basse tension. Ils sont très sensibles à l'induction et ne présentent aucune fiabilité à proximité d'ouvrages à haute tension, en exploitation.

D'autres dispositifs existants utilisent une lampe au néon ou une lampe à gaz rare. L'éclairage de la lampe au néon est détecté par une cellule photoélectrique, par exemple une résistance photoélectrique qui commande un générateur sonore et/ou lumineux. Eventuellement, un éclateur est interposé entre la ligne et l'électrode de la lampe au néon.

D'autres dispositifs existants comprennent des diviseurs de tension résistifs qui abaissent la tension traversant l'appareil à une valeur compatible avec un détecteur à seuil.

Enfin, des dispositifs connus comportent simplement un éclateur dont l'une des électrodes est connectée à une sonde et l'autre à un boîtier métallique formant cage de Faraday.

Cependant, dans les dispositifs de détection de tension alternative actuellement connus, c'est une tension alternative qui est appliquée à l'élément détecteur du seuil.

Le seuil de fonctionnement de ces dispositifs n'est pas stable du fait que la tension ne dépasse ce seuil que par intermittence, compte tenu des alternances de la tension des réseaux, théoriquement sinusoïdales.

Par ailleurs, les lignes et installations à haute et très haute tension alternative reçoivent des surtensions et ondes raides qui perturbent le fonctionnement correct de ces dispositifs, lesquels, en outre, sont sensibles aux décharges hautes fréquences et à l'ionisation de l'air.

Le manque de stabilité du seuil de fonctionnement est la source de doutes ou d'erreurs dans la reconnaissance de l'état de coupure ou de non coupure d'un ouvrage à proximité d'installations à haute et très haute tension en exploitation, donc générateur d'accidents électriques graves.

Pour la sécurité du personnel exploitant, il est indispensable de pouvoir disposer de dispositifs fiables permettant de distinguer d'une manière sûre et précise une tension induite d'une tension réelle sur lesdites installations.

On connaît déjà par le brevet SEGIM FR-A-2.432.174 une structure d'un détecteur unipolaire de tension alternative à diviseur capacitif. Toutefois, ce détecteur à sensibilité commutable ne présente que deux seuils de détection.

On connaît également par le brevet HORSTMANN DE-A-1.253.812 un contrôleur de tension à seuil réglable, cependant ce détecteur présente un diviseur de tension à transformateur qui est délicat à réaliser en haute tension.

Un des buts de la présente invention est de proposer un dispositif détecteur à seuil qui remédie à l'ensemble de ces inconvénients, c'est-à-dire, qui soit plus fiable et plus précis pour la détermination du seuil au-delà duquel le détecteur réagit pour distinguer une tension induite d'une tension réelle.

Un autre but de la présente invention est de proposer un dispositif d'une grande simplicité et d'une sécurité de fonctionnement absolue. Le dispositif comprend une sonde conductrice pour mettre en contact avec les conducteurs électriques à l'aide, par exemple, d'une perche isolante, un blindage protecteur et des moyens avertisseurs qui fonctionnent lorsque la tension dépasse le seuil de fonctionnement préréglé.

Il est caractérisé par le fait qu'un étage redresseur transforme une fraction de la tension alternative en tension sensiblement continue qui est comparée à un seuil variable mais déterminé.

L'invention est exposée ci-après plus en détail à l'aide de dessins représentant seulement un mode d'exécution.

La figure 1 représente le schéma de principe du dispositif selon la présente invention.

La figure 2 est relative à un mode de réalisation non limitatif du dispositif selon la présente invention.

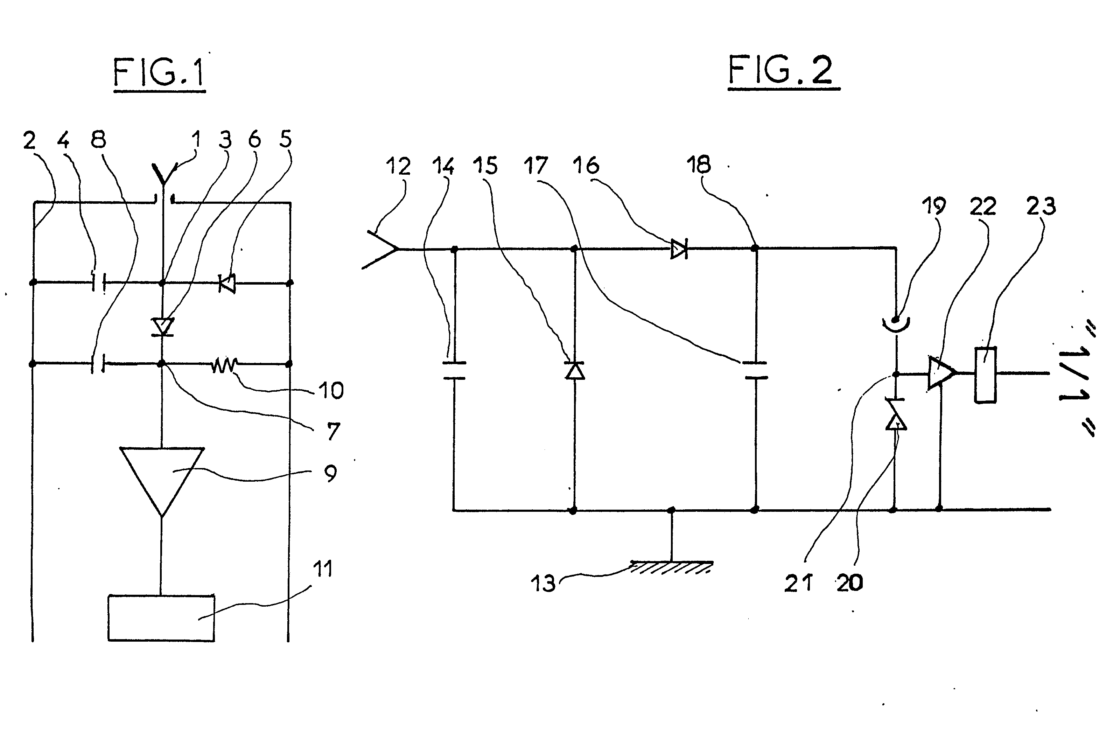

Dans la figure 1, on a représenté schématiquement dans son principe le dispositif détecteur selon la présente invention.

Il présente, tout d'abord, une sonde conductrice 1, de tout type approprié, pour être mise en contact avec un conducteur électrique.

L'Homme de l'Art déterminera facilement la sonde la plus appropriée par la nature des installations ainsi que la zone de la ligne la plus appropriée pour effectuer la vérification d'absence de tension. Un blindage de protection 2 entoure les éléments du dispositif. Ce blindage est de tout type approprié et, en particulier peut être recouvert d'un matériau isolant.

Ce blindage assure une protection de la partie électronique et constitue une armature de condensateur.

La sonde 1 est connectée électriquement à un point 3 situé dans la zone protégée par le blindage. Entre ce point 3 et la masse, constituée par le blindage 2, se trouve un condensateur 4. Ce condensateur 4 constitue l'un des éléments d'un diviseur capacitif fictif. L'autre élément, en effet, est constitué par le blindage et la terre, ou un élément métallique quelconque relié à la terre. Le condensateur 4 dérive donc une partie déterminée du courant alternatif traversant l'appareil, cette partie étant elle-même fonction de la capacité du condensateur que l'Homme de l'Art déterminera facilement.

La tension entre le point 3 et le blindage 2 est ensuite redressée de préférence par deux diodes 5 et 6. La diode 5 est située entre le point 3 et le blindage 2 et est passante de préférence du blindage vers le point 3. La diode 6 est située entre le point 3 et un point 7, et est passante du point 3 vers le point 7, compte tenu du sens passant de la diode 5.

On peut aussi monter les diodes en sens inverse si l'étage suivant exige une autre polarité.

Entre le point 7 et le blindage 2 est connecté un condensateur 8 de filtrage, ou d'une manière générale, un composant ou une pluralité de composants destinés à filtrer la tension redressée. Ainsi, au point 7, la tension est redressée et filtrée.

C'est au point 7 que la tension reçue, qui est redressée puis filtrée, est comparée à un seuil variable mais déterminé.

Dans la figure 1, l'élément détecteur à seuil est schématisé par un détecteur à seuil amplificateur 9, d'un type connu, dont la tension d'empreinte qui le pilote est prise aux bornes d'une charge 10, schématisée par une résistance en figure 1, branchée entre le point 7 et le blindage 2.

En sortie, le détecteur à seuil amplificateur 9 pilote des moyens avertisseurs que l'on a schématisés en 11. Ces moyens avertisseurs sont de tout type approprié, par exemple visuels ou sonores.

Ainsi, la tension mesurée au niveau de la sonde 1 est divisée, redressée puis filtrée. La comparaison avec un seuil déterminé est réalisée par un détecteur à seuil amplificateur aux bornes d'une charge.

De ce fait, c'est une tension redressée et filtrée qui est comparée à un seuil. Par ailleurs, les perturbations de la ligne sur laquelle est connectée la sonde 1 sont évitées. Le dispositif est, par ailleurs, insensible aux décharges haute fréquence qui se manifestent en particulier avec la production des étincelles lorsqu'on approche l'appareil d'un conducteur HT sous tension.

L'Homme de l'Art déterminera facilement la valeur et les caractéristiques à donner aux différents composants du dispositif. En particulier, la tension au point est déterminée par la capacité du condensateur 4, et par l'impédance ou plus précisément la résistance de la charge 10.

Naturellement, de nombreuses variantes pourraient être adoptées.

En particulier, au niveau du redressement, celui-ci pourrait être réalisé par quatre diodes disposées en pont, tel que cela est bien connu de l'Homme de l'Art.

La figure 2 schématise le dispositif selon la présente invention, dans un mode non limitatif de réalisation. De même que dans la figure 1, ce dispositif présente une sonde 12 et un blindage 13 de protection, qui a été schématisé par une masse. Entre la sonde 12 et la masse 13, le condensateur 14 dérive une partie du courant, qui est redressé ensuite par les diodes 15 et 16 puis filtré par le condensateur 17. La disposition des différents composants est sensiblement la même que celle des composants 4, 5, 6 et 8 de la figure 1. Le point 18 de la figure 2 joue donc sensiblement le même rôle que le point 7 de la figure 1.

Dans le mode de réalisation schématisant la figure 2, le seuil est détecté par une lampe à gaz rare, telle qu'une lampe au néon 19. Lorsque la tension aux bornes de cette lampe dépasse la tension d'amorçage, qui est de l'ordre de 100 Volts, "la lampe" conduit. Elle fonctionne donc comme un interrupteur à seuil, le seuil étant défini sensiblement par la tension d'amorçage.

En série avec la lampe au néon 19, se trouve une charge 20 qui la relie à la masse. L'apparition d'une tension aux bornes de cette charge 20, c'est-à-dire entre le point 21 et la masse, signifie que la lampe au néon conduit, et que donc la tension dépasse le seuil déterminé.

Cette tension au point 21 pilote des moyens avertisseurs d'un type connu, par exemple sonores ou visuels, schématisés en 23. De préférence, ces moyens avertisseurs sont commandés par un dispositif amplificateur de tension schématisé en 22. Ce dispositif peut être un circuit du type MOS, un transistor FET ou tout autre dispositif approprié à la portée de l'Homme de l'Art.

De préférence, la charge 20 est une diode Zéner montée en opposition compte tenu de la polarisation du point 18. Cette diode Zéner protège l'amplificateur de tension 22 et les moyens avertisseurs 23. En effet, lorsque la tension au point 18 dépasse la tension d'amorçage de la lampe au néon d'une valeur supérieure à la tension de claquage de la diode Zéner, sa résistance devient très faible et la tension au point 21 également très faible. Les circuits 22 et 23 sont donc ainsi protégés d'une surtension. La diode Zéner sera donc choisie avec une tension de claquage au plus égale à la tension pour laquelle les circuits 22 et 23 risquent d'être détériorés.

Il faut remarquer qu'en cas de claquage de la diode Zéner, le dépassement du seuil est détecté, étant donné que le circuit 22 est un amplificateur de tension et que la tension au point 21, si elle est très faible, n'est pas nulle.

L'Homme de l'Art déterminera facilement la nature et les caractéristiques les plus appropriées pour les différents composants, en particulier pour adapter le dispositif à la valeur supposée de la tension, aux normes de mesure et de sécurité en vigueur.

Dans le cas de lignes aériennes, le dispositif selon la présente invention peut être placé à l'extrémité d'une perche isolante, et les moyens avertisseurs, ou tout au moins une partie ramenée à l'autre extrémité de cette perche, ou tout au moins à proximité de celle-ci. Le dispositif pourrait être enfermé également dans un boîtier isolant, de manière à satisfaire aux normes de sécurité en vigueur.

D'autre part, de préférence, le dispositif peut comporter des moyens d'autocontrôle de bon fonctionnement que l'Homme de l'Art pourra facilement déterminer.

La description du dispositif selon l'invention, et en particulier celle du dispositif de la figure 2, n'est donnée qu'à titre indicatif et l'on pourrait adapter d'autres mises en oeuvre de la présente invention, sans pour autant sortir du cadre de celui-ci.

Revendications

1. Dispositif portatif unipolaire de vérification d'absence de tension sur des installations à haute et très haute tension alternative à seuil de fonctionnement variable mais déterminé, comprenant une sonde conductrice (1), un blindage protecteur (2) et des moyens avertisseurs (11) qui fonctionnent lorsque la tension d'exploitation dépasse ledit seuil, caractérisé par le fait qu'un étage redresseur (5) et (6) transforme une fraction de la tension alternative en tension sensiblement continue, qui est comparée à un seuil variable mais déterminé.

2. Dispositif selon la revendication 1, caractérisé par le fait que ledit étage redresseur (5) et (6) est directement suivi d'un étage de filtrage (8) et que la tension alternative redressée filtrée est comparée à un seuil variable mais déterminé.

3. Dispositif selon la revendication 2, caractérisé par le fait que la tension alternative redressée filtrée, est appliquée aux bornes d'une charge en parallèle (10) ou en série avec un détecteur de seuil (9) qui pilote des moyens avertisseurs (11).

4. Dispositif selon l'une quelconque des revendications 2 ou 3, caractérisé par le fait que la tension alternative redressée filtrée, est appliquée aux bornes d'une lampe au néon (19) en série avec une charge (20) et que la tension aux bornes de cette charge pilote les moyens avertisseurs (23).

5. Dispositif selon l'une quelconque des revendications 3 ou 4, caractérisé par le fait que ladite charge est une résistance (10).

6. Dispositif selon la revendication 4, caractérisé par le fait que ladite charge est une diode Zéner (20) montée en opposition dont la tension de claquage est choisie de manière à constituer une protection pour les éléments en aval lorsque la tension nominale est supérieure au seuil.

7. Dispositif selon la revendication 1, caractérisé par le fait que l'étage redresseur comprend deux diodes (5) et (6), montage double tension.

8. Dispositif selon l'une quelconque des revendications précédentes, caractérisé par le fait que la tension redressée est prise aux bornes d'un condensateur (4) branché entre la sonde conductrice (1) et le blindage (2), qui constitue l'un des éléments d'un diviseur capacitif, l'autre élément étant constitué par le blindage (2) et la terre.

9. Dispositif selon l'une quelconque des revendications 3 à 6, caractérisé par le fait que les moyens avertisseurs (23) sont pilotés par des moyens amplificateurs de tension (22) tels que les circuits MOS, FET, etc....

FIG.1

FIG.2

2  4  8      1  3  6  5

12  14  15  17  16      18

19  22  23

10

7

9

21  20

11

13

"1/1"

0061983

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int. Cl. ³) |
|---|---|---|---|
| A | FR - A - 2 432 174 (SEGIM)<br><br>* figure 1; revendication 1 *<br><br>--- | 1,8 | G 01 R 19/155 |
| A | DE - B - 1 253 812 (H. HORSTMANN)<br><br>* figure et revendication 1*<br><br>--- | 1-4 | |
| A | US - A - 3 956 697 (M. NERY)<br><br>* colonne 2, lignes 30-45 *<br><br>& FR - A - 2 186 650<br><br>--- | 1 | |
| A | CH - A - 467 455 (S. PEYER)<br><br>* figure 2; colonne 4, lignes 10-12 *<br><br>--- | 6 | **DOMAINES TECHNIQUES RECHERCHES (Int. Cl. ³)**<br><br>G 01 R  1/00<br>15/00<br>19/00 |
| A | DE - C - 937 299 (H. WURZ et al.)<br><br>* figure 1 *<br><br>-------- | 7 | |

Le présent rapport de recherche a été établi pour toutes les revendications

| Lieu de la recherche | Date d'achèvement de la recherche | Examinateur |
|---|---|---|
| La Haye | 04.06.1982 | MIELKE |

CATEGORIE DES DOCUMENTS CITES

X : particulièrement pertinent à lui seul
Y : particulièrement pertinent en combinaison avec un autre document de la même catégorie
A : arrière-plan technologique
O : divulgation non-écrite
P : document intercalaire

T : théorie ou principe à la base de l'invention
E : document de brevet antérieur, mais publié à la date de dépôt ou après cette date
D : cité dans la demande
L : cité pour d'autres raisons

& : membre de la même famille, document correspondant

OEB Form 1503 03 82